(19) Europäisches Patentamt / European Patent Office / Office européen des brevets

(11) **EP 2 533 311 A1**

(12) **EUROPEAN PATENT APPLICATION**
published in accordance with Art. 153(4) EPC

(43) Date of publication:
**12.12.2012 Bulletin 2012/50**

(51) Int Cl.:
*H01L 33/48* (2010.01)   *C04B 35/00* (2006.01)
*H01L 23/12* (2006.01)   *H01L 23/15* (2006.01)
*H01L 33/60* (2010.01)

(21) Application number: **10845257.4**

(22) Date of filing: **30.11.2010**

(86) International application number:
**PCT/JP2010/071390**

(87) International publication number:
**WO 2011/096126 (11.08.2011 Gazette 2011/32)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.02.2010 JP 2010024630**

(71) Applicant: **Asahi Glass Company, Limited
Tokyo 100-8405 (JP)**

(72) Inventors:
• **OKADA, Toshihisa
Tokyo 100-8405 (JP)**

• **IMAKITA, Kenji
Tokyo 100-8405 (JP)**
• **MICHIMATA, Hitoshi
Tokyo 100-8405 (JP)**

(74) Representative: **Müller-Boré & Partner
Patentanwälte
Grafinger Straße 2
81671 München (DE)**

(54) **SUBSTRATE FOR MOUNTING LIGHT-EMITTING ELEMENT, AND LIGHT-EMITTING DEVICE**

(57) To provide a substrate for mounting a light-emitting element having a reflectance increased since light which is transmitted through the substrate and leaks out in directions other than the direction from which the light enters is reduced, and having a reduced firing shrinkage in the plane direction.

A substrate for mounting a light-emitting element of the present invention is made of a glass ceramic 10 containing glass 1 and a flat oxide type ceramic filler 2 having an average aspect ratio of at least 25 dispersed in the glass 1. The ceramic filler 2 is contained in a state where it is aligned in parallel with the plane direction of the substrate, and the glass ceramic 10 contains no crystals except for the ceramic constituting the filler. This substrate has an extremely high reflectance of at least 84% (thickness: 300 μm) to light in the visible region.

F i g.1

**Description**

TECHNICAL FIELD

The present invention relates to a substrate for mounting a light-emitting element and a light-emitting device using it, particularly a substrate for mounting a light-emitting element having a high reflectance of light in the visible region, and a light-emitting device using the substrate for mounting a light-emitting element.

BACKGROUND ART

In recent years, along with a tendency to high brightness and whitening of a light-emitting diode (LED) element, a light-emitting device employing a LED element has been developed for e.g. backlights of cellular phones or large-sized liquid crystal TVs. In such a light-emitting device, as a substrate on which a light-emitting element such as a LED element is to be mounted, one which has high thermal conductivity, from which heat generated from the light-emitting element is quickly dissipated and in addition, which has a high reflectance of light in the visible region and which can easily be produced, has been desired.

To meet such requirements, use of a low temperature co-fired ceramic substrate (hereinafter referred to as a LTCC substrate) as the substrate for mounting a light-emitting element has been studied. The LTCC substrate is obtained by overlaying a predetermined number of green sheets comprising glass and a ceramic filler (for example, an alumina filler), and bonding them by thermal compression, followed by firing.

In production of such a LTCC substrate, it is important to suppress the shrinkage at the time of firing (firing shrinkage) to be low. As a method of controlling the firing shrinkage, there are a controlling method by a production process and a controlling method by a material constituting the substrate. With respect to control by a production process, although there are practical methods, there are problems such as an increase in the process cost. On the other hand, a technique to control the firing shrinkage by a constituting material has not yet been studied sufficiently at the present time.

Further, when production conditions such as pressing conditions or firing conditions are changed, or when the lot of the constituting material is changed, a problem such that the firing shrinkage varies usually arises, and it is necessary to change the printing mask, the punching (sheet punching) data, etc. each time. Accordingly, it is difficult to change the production conditions remarkably, and the constituting material is very strictly restricted in many cases.

Further, the LTCC substrate has a high reflectance of light as compared with a ceramic substrate such as an alumina substrate, since the difference in the refractive index between glass and the ceramic filler is significant, and the interface between them is a lot. However, a substrate having a further higher reflectance has been desired as a substrate for mounting a light-emitting element.

Heretofore, in order to increase the reflectance of a glass ceramic substrate, a method of incorporating a filler (high refractive index filler) of a ceramic having a refractive index higher than that of alumina has been studied. However, one containing a high refractive index filler is poor in the sintering property as compared with one containing a filler of e.g. alumina or silica ($SiO_2$), and accordingly, the content of the high refractive index filler cannot be made high, or the composition of glass is significantly restricted. Thus, the degree of freedom of the design is decreased. Accordingly, in order to select the glass composition from a wide range, a technique to increase the reflectance of light by using an alumina filler or the like having good sintering property with glass has been desired.

As a glass ceramic substrate using flat particles having a high aspect ratio as the ceramic filler, the following proposal has been made. That is, a process for producing a glass ceramic substrate, which comprises firing a green sheet comprising a glass powder and a filler containing flat particles, in a state where the flat particles are aligned in parallel with the plane direction, is proposed (for example, Patent Document 1).

However, by the process as disclosed in Patent Document 1, a substrate having a sufficiently high reflectance as a substrate for mounting a light-emitting element cannot be obtained. That is, a ceramic powder composed of an oxide or a metal powder has been used as flat particles, however, a ceramic powder having an aspect ratio of about 5 is used, and with one containing a filler having an aspect ratio at this level, a high reflectance cannot be achieved.

Further, although a metal filler (such as an aluminum filler) having a higher aspect ratio than that of such a ceramic powder is used, a substrate containing a metal filler cannot have a high reflectance from the following reasons. That is, a metal (for example, aluminum) has such a property that it absorbs part of incident light when it reflects light. Further, it is known that when light enters into a glass substrate containing a filler, multiple reflection usually occurs at the interface between glass and the filler until the light is reflected from the substrate. Accordingly, with a substrate containing metal aluminum as the metal filler, most of the incident light is absorbed in the metal filler at the multiple reflection, whereby the reflected light from the substrate is significantly reduced, thus leading to a low reflectance.

Further, a glass ceramic substrate having thermal conductivity (heat dissipation property) improved by dispersing a ceramic filler having an aspect ratio of at least 4 in glass and/or in a matrix in which glass is crystallized, has been proposed (for example, Patent Document 2).

However, with the glass ceramic substrate disclosed in Patent Document 2 also, a sufficiently high reflectance cannot be achieved, since a ceramic filler having an aspect ratio of at most 10 is dispersed and contained.

Further, a light reflector having a high reflectance, which is a glass ceramic substrate containing glass and ceramic particles (including one having an aspect ratio of at least 3), and which has a degree of crystallization of the glass ceramic of at least 50%, has been proposed (for example, Patent Document 3).

However, the light reflector disposed in Patent Document 3 is to realize a high reflectance by crystallizing glass during firing to form very fine crystals, and is produced by using a powder of crystallized glass. As it is difficult to stably induce crystallization by using a powder of crystallized glass, the variation of the reflectance is significant in a high reflector achieved by crystallization of glass. Further, in a case where a substrate with a very high crystallization potential is fired, warpage may occur at the edge of the substrate.

PRIOR ART DOCUMENTS

PATENT DOCUMENTS

Patent Document 1: JP-A-9-071472
Patent Document 2: JP-A-2002-111210
Patent Document 3: JP-A-2007-121613

DISCLOSURE OF INVENTION

TECHNICAL PROBLEM

The present invention has been made to solve the above problems, and its object is to provide a substrate for mounting a light-emitting element, which has a low firing shrinkage in the substrate plane direction, of which the plane shrinkage at the time of firing can optionally be controlled, and which has a reflectance increased since light which is transmitted through the substrate and leaks out to directions other than the direction from which the light enters (that is, outgoing light) is reduced.

Particularly, the object is to provide a substrate for mounting a light-emitting element of which the plane shrinkage can be controlled to be at most 15.0%. Further, the object of the present invention is to provide a light-emitting device having a high light-emitting brightness using the above substrate for mounting a light-emitting element.

SOLUTION TO PROBLEM

The substrate for mounting a light-emitting element of the present invention is a glass ceramic substrate made of a sintered product of a glass ceramic composition containing a glass powder and a flat ceramic filler having an average aspect ratio of at least 25, made of an oxide, and containing no crystals except for the ceramic constituting the filler, wherein the ceramic filler is aligned in parallel with the plane direction of the substrate, and the reflectance of light in the entire visible region (specifically light in a wavelength region of from 400 to 700 nm) is at least 84% at a thickness of 300 $\mu$m.

The average major axis of the ceramic filler is preferably at least 1 $\mu$m and at most 5 $\mu$m. Further, the average aspect ratio of the flat ceramic filler is preferably at least 25 and at most 200. Further, in the glass ceramic composition, the blend ratio of the ceramic filler is preferably from 30 to 60 vol%. Further, it is preferred that in the glass ceramic composition, the blend ratio of the ceramic filler is from 30 to 60 vol%, and the blend ratio of the glass powder is from 40 to 70%. Further, in the glass ceramic composition, the glass powder is preferably non-crystallized glass. The non-crystallized glass here means that it is not crystallized when co-fired with the ceramic filler. Further, when the refractive index of the glass constituting the glass powder is "a", and the refractive index of the ceramic constituting the filler is b, the absolute value of b-a is preferably at least 0.15. Further, it is preferred that of the ceramic filler, the value of (average aspect ratio $\times$ blend ratio (vol%) $\times$ difference in the refractive index with glass)/average major axis ($\mu$m) is at least 130.

The light-emitting device of the present invention comprises the above-described substrate for mounting a light-emitting element of the present invention, and a light-emitting element mounted on the substrate for mounting a light-emitting element.

ADVANTAGEOUS EFFECTS OF INVENTION

According to the present invention, by using a flat filler having an average aspect ratio of at least 25 made of an oxide type ceramic and incorporating the flat ceramic filler in a state where it is aligned in parallel with the plane direction of the substrate, the reflectance of the substrate for mounting a light-emitting element to light in the visible region can be increased, and a high reflectance of at least 84% at a thickness of 300 $\mu$m of the substrate for mounting a light-emitting element can be realized. Further, by mounting a light-emitting element on such a substrate for mounting a light-emitting element, a light-emitting device having high brightness and good properties can be obtained.

BRIEF DESCRIPTION OF DRAWINGS

Fig. 1 is a longitudinal cross sectional view schematically illustrating the fine structure of a glass ceramic constituting a substrate for mounting a light-emitting element of the present invention in the thickness direction.
Fig. 2 is a cross sectional view illustrating one example of a light-emitting device of the present invention.

DESCRIPTION OF EMBODIMENTS

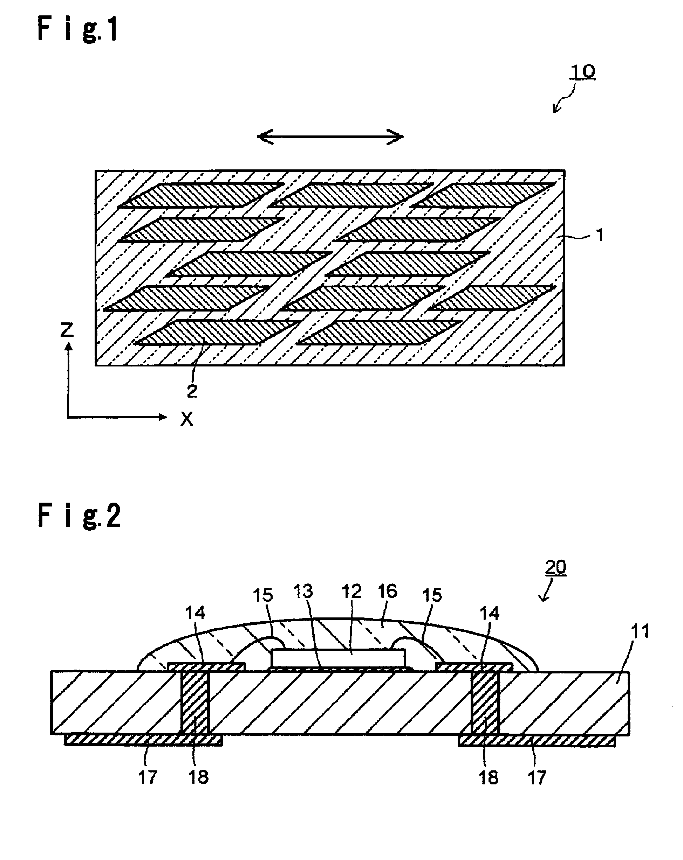

Now, the embodiments of the present invention will be described in detail below.
The substrate for mounting a light-emitting element of the present invention is constituted by a glass ceramic which is a sintered product of a glass ceramic composition containing a glass powder and a flat (i.e. flaky) ceramic filler having an average aspect ratio of at least 25. The upper limit of the average aspect ratio of the flat ceramic filler is preferably at most 200, more preferably at most 100. If the average aspect ratio is too high, the flat filler tends to be thin, whereby in the mixing operation by a ball mill at the time of slurry preparation, it may be ground by the ceramic balls. Further, if the aspect ratio is too high, the proportion of the flat area which is likely to lead to an increase in the surface area and interaction among particles, tends to be high, whereby it tends to be difficult to uniformly disperse the filler at the time of slurry preparation. Thus, there may be unevenness of the composition in the green sheet, it tends to be difficult to make the thickness uniform, or the subsequent LTCC production step may be impaired.
Such a glass ceramic 10 comprises, as shown in Fig. 1, glass 1 and a flat ceramic filler 2 dispersed in the glass 1. The flat ceramic filler 2 is contained in a state where its major axis is aligned in parallel with the plane direction (represented by an arrow in the drawing) of the substrate.
In the present invention, the aspect ratio means, as shown in Fig. 1, a value obtained by dividing the major axis (supposing the flat plane as an x-y plane, for example, the size in the x-axis direction) of each flat filler particle 2 by the thickness (the length in the z-axis direction vertical to the flat plane). In the present invention, a flat and flaky ceramic filler having an average of such an aspect ratio of at least 25 is used. Further, a plural types of flat ceramic fillers may be used as mixed, and in such a case, a value which is a sum of values obtained by multiplying the aspect ratios of the respective ceramic fillers by their proportions, is regarded as the average aspect ratio.
In the glass ceramic of the present invention, containing no crystals except for the ceramic constituting the filler means that substantially no crystals derived from the glass composition of the glass powder and precipitating from glass at the time of firing are formed. That is, it means that the glass powder when co-fired with the ceramic filler functions as a non-crystallized glass. The degree of crystallization and the type of crystals of the glass ceramic 10 can be examined by XRD (X-ray diffraction) measurement. For example, it means that no peak derived from glass having an intensity of at least 10 by the absolute value appears where the maximum intensity (absolute value) of a peak derived from the ceramic of the filler is 100 in the measured XRD chart. As mentioned above, by substantially no crystals derived from the glass composition being formed at the time of firing, insufficient sintering is less likely to occur. Further, as the thermal expansion coefficient of the glass ceramic will not change at the time of firing, the substrate is less likely to have drawbacks such as warpage. Further, as substantially no formation of crystals derived from the glass composition leads to no reduction of the amount of glass in the glass ceramic, the amount of introduction of the flat filler which can stably improve the reflectance can be increased.
For the glass ceramic substrate of the present invention, a flat ceramic filler 2 having an average aspect ratio of at least 25 is used, and it is contained in a state where the major axis of the ceramic filler 2 is aligned in parallel with the plane direction of the substrate. Accordingly, such a substrate can have an extremely high reflectance of at least 84% to light (wavelength: 400 to 700 nm) in the entire visible region at a thickness of 300 $\mu$m. That is, light which entered into the substrate from above the substrate undergoes repetition of reflection or refraction due to the difference in the refractive index between glass and the ceramic at an interface between the glass 1 and the ceramic filler 2. In the glass ceramic substrate of the present invention, as the flat ceramic filler 2 having an extremely high aspect ratio of at least 25 is dispersed as aligned in parallel with the plane direction of the substrate, and accordingly the number of collision of the incident light with the interface between glass and the ceramic filler increases as compared with a substrate having a ceramic filler having a smaller aspect ratio dispersed and contained. By the increase in the number of collision (i.e. reflection or refraction) at the interface, light which is transmitted through the substrate in the thickness direction and leaks in direction other than the above (that is, outgoing light), is reduced. Thus, the amount of reflected light which returns to the above the substrate can be increased.

Further, of the glass ceramic substrate of the present invention, as described hereinafter, shrinkage in the plane direction at the time of firing is suppressed, whereby a high dimensional accuracy can be realized. Further, the plane shrinkage at the time of firing can optionally be controlled by adjusting the content of the ceramic filler or the average aspect ratio. Such leads to the feasibility of quick and accurate countermeasures against a problem of an accompanying change in the firing shrinkage when production conditions such as pressing conditions or firing conditions are changed or when the lot of the material is changed, such being very preferred in view of production of the glass ceramic substrate.

The ceramic filler 2 constituting the glass ceramic substrate of the present invention may, for example, be an oxide type ceramic such as alumina, silica, mica, zirconia, boehmite or talc. A flat ceramic filler having an average aspect ratio of at least 25 is used. If the average aspect ratio of the oxide type ceramic filler 2 is less than 25, it tends to be difficult to realize a sufficiently high reflectance (i.e. at least 84% at a thickness of substrate of 300 $\mu$m) as the substrate for mounting a light-emitting element. Further, the proportion of the ceramic filler 2 in the glass ceramic substrate is preferably from 30 vol% to 60 vol%. Further, a plural types of ceramic fillers differing in the aspect ratio may be mixed. Further, as the oxide type ceramic filler has good sintering property with glass as compared with a metal filler, the content of the ceramic filler can be made higher, and such is advantageous in that the glass composition is less likely to be restricted.

Further, part of the flat ceramic filler 2 represented by the above may be replaced with a particulate and non-flat filler having an average aspect ratio less than 25, such as $Al_2O_3$, $SiO_2$, $ZrO_2$, $TiO_2$, $MgO$, mullite, AIN, $Si_3N_4$, SiC or forsterite. The amount of replacement with the particulate filler is preferably at most 20 vol% of the entire glass ceramic substrate.

Further, in order to obtain a high reflectance, the major axis of the ceramic filler 2 is preferably at least 1 $\mu$m and at most 5 $\mu$m on average. A ceramic filler having a major axis less than 1 $\mu$m may be contained up to 20 vol% of the entire glass ceramic substrate. If its proportion exceeds 20 vol%, fluidity of glass at the time of firing may be decreased due to an increase in the surface area, thus deteriorating the sintering property. Further, a ceramic filler having a major axis exceeding 5 $\mu$m may be contained up to 20 vol% of the entire glass ceramic substrate. If its proportion exceeds 20 vol%, the reflectance tends to be lowered by a decrease in the interface between the ceramic filler and glass. Further, the binding power of the flat ceramic filler in the plane direction at the time of firing tends to be weak, and the effects to reduce the firing shrinkage may not be expected.

The glass 1 constituting the glass ceramic substrate of the present invention is not necessarily limited so long as it has a composition which is less likely to form crystals in a firing temperature range when co-fired with the ceramic filler. If high reflection is to be realized by utilizing the refractive index difference caused at the interface between the crystalline portion and the non-crystalline portion by using a crystallized glass which forms a large quantity of crystals, crystals will hardly be precipitated stably at the time of firing, whereby there may be a significant variation in the reflectance of the obtainable substrate, and a high reflectance will hardly be obtained stably. Further, the substrate may have warpage. Further, the glass 1 constituting the glass ceramic substrate of the present invention is preferably one having a difference in the refractive index with the ceramic filler 2 of at least 0.15. That is, when the refractive index of glass comprising the above glass powder is "a", and the refractive index of the ceramic filler is b, |b-a| (absolute value of b-a) is preferably at least 0.15, more preferably at least 0.17, further preferably at least 0.19. If the difference in the refractive index between the glass and the ceramic filler is less than 0.15, the degree of scattering at the interface is lowered, whereby a high reflectance will hardly be realized.

Such glass may be alumina borosilicate glass, more preferably $SiO_2$-$B_2O_3$-$Al_2O_3$-MO type (wherein M is an alkaline earth) glass. To realize a high reflectance, the difference in the refractive index between glass and the ceramic is preferably large. The refractive index of glass can be calculated by the coefficient of Appen. The additive factors (coefficients) of the respective components in alkali-containing silicate glass are shown in Table 1 (source: A. A. Appen, Chemistry of Glass, Nisso Tsushin-Sha (1974) Page 318).

TABLE 1

|  | Additive factors |
|---|---|
| $SiO_2$ | 1.46-1.48 |
| $B_2O_3$ | 1.46-1.71 |
| $Al_2O_3$ | 1.52 |
| $MgO$ | 1.61 |
| $CaO$ | 1.73 |
| $SrO$ | 1.78 |

(continued)

|  | Additive factors |
|---|---|
| $Na_2O$ | 1.59 |
| $K_2O$ | 1.58 |
| $TiO_2$ | 2.13 |
| $ZrO_2$ | 2.20 |
| LiO | 1.70 |
| ZnO | 1.71 |

$SiO_2$ and $B_2O_3$ to be a glass network former and $Al_2O_3$ to increase the stability, the chemical durability and the strength of glass, are required to be contained in a certain ratio or more, also with a view to preparing glass having a low refractive index. The total content of $SiO_2+B_2O_3+Al_2O_3$ is at least 57 mol%, preferably at least 62 mol%, further preferably at least 67 mol%.

In the glass composition of the glass powder used in the present invention, it is preferred to add from 10 to 35 mol% of an alkaline earth metal oxide so as to increase the stability of glass and to lower the glass melting temperature or the glass transition point (Tg). If the content of the alkaline earth metal oxide is less than 10 mol%, the glass melting temperature may excessively be high. On the other hand, if the content of the alkaline earth metal oxide exceeds 35 mol%, the refractive index of glass is increased, and the difference in the refractive index between glass and the ceramic filler (for example, an alumina filler) tends to be small, whereby no high reflectance can be expected. The content of the alkaline earth metal oxide is preferably from 15 to 30 mol%, more preferably from 20 to 30 mol%.

An alkali metal oxide such as $K_2O$ or $Na_2O$ to be added to lower the glass transition point (Tg) may be added in an amount of from 0 to 10 mol%. Such an alkali metal oxide is preferably contained with a view to preparing a low refractive index glass, since its degree of increasing the refractive index is remarkably low as compared with the alkaline earth metal oxide. However, if the total content of $K_2O$ and $Na_2O$ exceeds 10 mol%, the chemical durability particularly the acid resistance may be decreased, and the electrical insulating properties may be decreased. The total content of $K_2O$ and $Na_2O$ is preferably from 1 to 8 mol%, more preferably from 1 to 6 mol%.

ZnO, $TiO_2$ and SnO may be added for the purpose of lowing the softening point like the alkaline earth metal oxide. However, the addition amount of such components is preferably suppressed to be at most 20 mol%, since their degree of increasing the refractive index is high as compared with other additive components.

The glass is not limited to one consisting solely of the above components, and may contain other components within a range to satisfy various properties such as the difference in the refractive index with the ceramic filler. If it contains other components, their total content is preferably at most 10 mol%.

The glass ceramic substrate which is the substrate for mounting a light-emitting element according to the embodiment of the present invention can be produced as follows. First, to a glass ceramic composition containing a glass powder and a flat ceramic filler having an average aspect ratio of at least 25, a binder and as the case requires, a plasticizer, a solvent, a leveling agent, a dispersing agent, etc. are added to prepare a slurry. This slurry is formed into a sheet form e.g. by a doctor blade method, followed by drying, to produce a green sheet.

The glass powder can be obtained by blending and mixing glass materials to achieve glass having the above composition, producing glass by a melting method, and grinding the glass by a dry grinding method or a wet grinding method. In the case of a wet grinding method, it is preferred to employ water as a solvent. The grinding can be carried out by using a grinding machine such as a roll mill, a ball mill or a jet mill.

The particle size of the glass powder is preferably such that the 50% particle size ($D_{50}$) is at least 0.5 $\mu$m and at most 3 $\mu$m. If the 50% particle size of the glass powder is less than 0.5 $\mu$m, the glass powder is likely to cohere, whereby the handling tends to be difficult, and it tends to be difficult to uniformly disperse it. On the other hand, if the 50% particle size of the glass powder exceeds 3 $\mu$m, the glass softening temperature is likely to rise, or the sintering is likely to be inadequate. The particle size can be adjusted, for example, by classification after the grinding as the case requires. In this specification, the particle size of a powder is a value measured by a particle size analyzer (manufactured by Nikkiso Co., Ltd., tradename: MT3100II) of a laser diffraction scattering method.

The glass ceramic composition can be obtained by blending and mixing the flat ceramic filler and the glass powder so that the blend ratio of the ceramic filler becomes at least 30 vol% and at most 60 vol%. The more preferred blend ratio of the ceramic filler is within a range of at least 35 vol% and at most 55 vol%. If the blend ratio of the ceramic filler is less than 30 vol%, in the obtainable glass ceramic substrate, the number of collision of the light which entered into the substrate with the interface between glass and the ceramic filler tends to be insufficient, whereby a high reflectance is hardly obtained. Further, shrinkage in the plane direction of the substrate at the time of firing cannot sufficiently be suppressed. In a case where the blend ratio of the ceramic filler exceeds 60 vol%, the blend ratio of glass tends to be too low, thus leading to poor sintering property. In this glass ceramic composition, the blend ratio of the glass powder is preferably within a range of at least 40 vol% and at most 70 vol%, and the more preferred blend ratio of the glass powder is within a range of at least 40 vol% and at most 60 vol%. If the blend ratio of the glass powder is less than 40 vol%, the amount of the glass tends to be too small, thus leading to insufficient sintering property and a decrease in the substrate strength, and the surface roughness is increased, whereby the contact thermal resistance at the interface with a LED chip tends to be increased, such being unfavorable. On the other hand, if the blend ratio of the glass powder exceeds 70 vol%, the interface between glass and the ceramic is reduced, whereby the proportion of the incident light which is transmitted to the rear side of the substrate tends to be increased, and a high reflectance may not be realized.

To such a glass ceramic composition, a binder is blended, and as the case requires, a solvent (organic solvent), a plasticizer, etc. are added to obtain a slurry.

The binder may, for example, be preferably polyvinyl butyral or an acrylic resin. The plasticizer may, for example, be dibutyl phthalate, dioctyl phthalate or butyl benzyl phthalate. Further, the solvent may be an aromatic or alcohol organic solvent such as toluene, xylene or butanol. It is preferred to use a mixture of an aromatic solvent with an alcohol solvent. Further, it is also possible to use a dispersing agent or a leveling agent in combination.

The slurry has a composition, for example, comprising 54.1 mass% of solid content (glass powder + ceramic filler), 36.5 mass% of an organic solvent (a solvent mixture of toluene, xylene, isopropyl alcohol (2-propanol) and 2-butanol), 0.8 mass% of a dispersing agent, 3.2 mass% of a plasticizer, and 5.4 mass% of a resin as a binder.

For preparation of the slurry, the glass powder and the ceramic filler having an average aspect ratio of at least 25 are added to a solvent mixture having a leveling agent and a dispersion agent mixed as the case requires with an organic solvent, and the mixture is stirred by a ball mill using $ZrO_2$ as a medium. A vehicle having a resin as a binder dissolved in an organic solvent is added thereto, followed by stirring by a propeller stirring rod, and the mixture is subjected to filtration through a mesh filter. Bubbles included in the interior can be removed by stirring in vacuum.

In the step of stirring and mixing the glass powder, the flat ceramic filler and the like in the organic solvent by a ball mill, breakage of the ceramic filler is concerned. However, the average major axis of the ceramic filler is at most 5 $\mu$m and is much smaller than the balls for stirring and grinding, and accordingly it is considered that the probability that the ceramic filler penetrates into gaps between balls and is ground at the time of collision of the balls is very low. Accordingly, in a mixing time to such an extent that the glass powder and the flat ceramic filler are dispersed in the organic solvent, substantially no breakage of the ceramic filler and thus decrease in the aspect ratio will occur.

In the after-mentioned Examples, an alumina filler having an average aspect ratio being maximum (70) was added, followed by stirring and grinding by a ball mill, to prepare a slurry. The cross section of the substrate obtained after firing was observed by SEM (scanning electron microscope), whereupon no breakage of the alumina filler was observed, and the alumina particles maintained a high aspect ratio.

Then, the obtained slurry was cast onto a PET film coated with a release agent, for example, by a doctor blade method to form a sheet, followed by drying to produce a green sheet. In such a green sheet thus produced, the above-mentioned flat ceramic filler is aligned so that the major axis direction is in parallel with the plane direction, and the reasons are considered to be as follows. That is, at the time of casting by a doctor blade method, the slurry containing the glass powder, the ceramic filler, etc. passes through a space formed by the tip of the blade portion of the doctor blade apparatus and the surface of the film, whereby the flow (streamline) of the slurry is along the film transportation direction. On that occasion, the ceramic filler dispersed in the slurry also passes through the space so as to be along the flow of the slurry. Accordingly, the ceramic filler in the green sheet is aligned so that the direction of the flat plane is in parallel with the plane direction of the sheet.

On the green sheet, non-fired wiring pattern, conductor for interfacial connection, external electrode terminal, etc. may be formed. The method of forming the non-fired wiring pattern or external electrode terminal is not particularly limited, and they may be formed by applying a conductor paste by a screen printing method. Further, the non-fired conductor for interfacial connection can be formed by forming a hole (via hole) for interfacial connection on the green sheet e.g. by punching, and filling the hole with the conductor paste by screen printing. As the conductor paste, it is possible to use one having a vehicle such as ethyl cellulose, and as the case requires, a solvent etc. added to a metal powder containing copper, silver, gold, aluminum or the like as the main component to form a paste.

Then, a plurality of the above green sheets are overlaid with positioning, and bonded by thermal compression. Then, binder burn out to decompose and remove the binder, etc. is carried out and then, firing is carried out to sinter the glass ceramic composition. In such a manner, a glass ceramic substrate for mounting a light-emitting element is obtained.

Binder burn out is carried out preferably by holding the substrate, for example, at a temperature of at least 500°C and at most 600°C for at least one hour and at most 10 hours. If the binder burn out temperature is lower than 500°C or the binder burn out time is less than one hour, the binder, etc. may not sufficiently be decomposed and removed. When the binder burn out temperature is about 600°C and the binder burn out time is about 10 hours, the binder, etc. can sufficiently be removed. However, if the binder burn out time exceeds 10 hours, the productivity, etc. may rather be deteriorated.

Firing is carried out by holding the substrate, for example, at a temperature of at least 850°C and at most 900°C for at least 20 minutes and at most 60 minutes, particularly preferably at a temperature of at least 860°C and at most 880°C. If the firing temperature is less than 850°C or if the firing time is less than 20 minutes, a dense sintered product may not be obtained. When the firing temperature is about 900°C and the firing time is about 60 minutes, a sufficiently dense product will be obtained, and if the firing temperature or the firing time exceeds the above range, the productivity, etc. may rather be deteriorated. Further, in a case where a conductor paste containing a metal powder containing silver as the main component is used, if the firing temperature exceeds 900°C, the conductor paste is softened too much, whereby the predetermined shape cannot be maintained.

When the flat ceramic filler is fired in a state where it is aligned in parallel with the plane direction of the green sheet, only the glass powder is melted while the alignment of the ceramic filler is as it is. On that occasion, the gaps between the ceramic filler particles are filled with the molten glass, and as the movement in the plane direction of the ceramic filler aligned in parallel with the plane direction is restricted, the gaps (dimensions) between the ceramic filler particles in the plane direction are maintained, and only the gap dimension in the thickness direction is reduced. Accordingly, shrinkage occurs only in the thickness direction at the time of firing the green sheet, and shrinkage in the plane direction is suppressed. Thus, the firing shrinkage in the plane direction is reduced without applying an external pressure, whereby a glass ceramic substrate with high dimensional accuracy can be obtained.

Further, the glass ceramic substrate thus obtained has a high light reflectance since the flat ceramic filler having an average aspect ratio of at least 25 made of an oxide ceramic, preferably a flat ceramic filler having an average aspect ratio of at least 25 and at most 200, is aligned in parallel with the plane direction of the substrate.

The substrate for mounting a light-emitting element of the present invention is described with reference to examples, however, various changes and modifications are possible without departing from the intension and the scope of the present invention, and as the case requires. Now, a light-emitting device of the present invention will be described.

As shown in Fig. 2, a light-emitting device 20 of the present invention comprises the above-mentioned substrate 11 for mounting a light-emitting element, and a light-emitting element 12 such as a light-emitting diode (LED) chip mounted on the mounting portion of the substrate. The light-emitting element 12 is fixed to the mounting portion by an adhesive 13, and an electrode (not shown) of the light-emitting element 12 is electrically connected to a connection terminal 14 formed on the substrate 11 for mounting a light-emitting element by means of a bonding wire 15. Further, a mold sealing layer 16 made of e.g. a resin is provided so as to cover the light-emitting element 12 and each bonding wire 15. The reference symbol 17 represents an external electrode terminal provided on the rear side of the substrate 11 for mounting a light-emitting element, and the reference symbol 18 represents a through hole conductor to electrically connect each external electrode terminal 17 and each connection terminal 14. A lid made of an optically transparent material such as glass may be used for sealing without using the mold sealing layer 16, or the mold sealing layer 16 and the lid may be used in combination. Further, a phosphor may be contained in the mold sealing layer 16 to conduct wavelength conversion of light emitted from the light-emitting element 12.

According to the light-emitting device 20 of the present invention, by using the substrate 11 for mounting a light-emitting element having a high reflectance, the light emitted from the light-emitting element 12 is reflected to the above with a high reflectance, whereby light emission with a high brightness can be obtained. Further, the shrinkage in the plane direction of the substrate 11 for mounting a light-emitting element at the time of firing is reduced, whereby the substrate 11 is excellent in the dimensional accuracy, and accordingly a light-emitting device with good properties is obtained. Such a light-emitting device 20 of the present invention can suitably be used, for example, for backlights of cellular phones or large-sized liquid crystal displays, illumination for automobiles or for decoration, or other light sources.

EXAMPLES

Now, the substrate for mounting a light-emitting element of the present invention will be described in detail with reference to specific Examples.

(Examples 1 to 6 and Comparative Examples 1 and 2)

The respective glass materials were blended and mixed to achieve glass comprising, as represented by mol% as calculated as the following oxides, 58.5 mol% of $SiO_2$, 7.7 mol% of $B_2O_3$, 8.0 mol% of $Al_2O_3$, 19.1 mol% of CaO, 1.5 mol% of $K_2O$, 1.5 mol% of $Na_2O$, 1.6 mol% of MgO, 0.3 mol% of LiO and 1.8 mol% of SrO, this material mixture was put in a platinum crucible and melted at from 1,550 to 1,600°C for 60 minutes, and glass in a molten state was cast and cooled. The obtained glass was ground by an alumina ball mill using ethyl alcohol as a solvent for from 20 to 60 hours to obtain a glass powder.

The glass transition point (Tg) of the obtained glass powder was measured by using a thermal analyzer (manufactured by Macscience, tradename: TG-DTA2000) at a temperature-raising rate of 10°C/min up to 1,000°C, whereupon Tg was 643°C. Further, the softening temperature (Ts) was 811°C.

Then, this glass powder and an alumina filler having an average aspect ratio (A) and an average major axis (d) as identified in Table 2 as a ceramic filler were mixed in a proportion as identified in Table 2.

In Example 1, an alumina filler having an average aspect ratio of 25 and an average major axis of 2 μm was used, in Example 2, an alumina filler having an average aspect ratio of 37.5 obtained by mixing an alumina filler having an average aspect ratio of 25 and an average major axis of 2 μm, and an alumina filler having an aspect ratio of 50 and the same average major axis (2 μm) in a mass ratio of 1:1, was used, in Examples 3 to 5, an alumina filler having an average aspect ratio of 50 and an average major axis of 2 μm was used, in Example 6, an alumina filler having an average aspect ratio of 70 and an average major axis of 5 μm was used, in Comparative Example 1, an alumina filler having an average aspect ratio of 5 and an average major axis of 2 μm was used, and in Comparative Example 2, an alumina filler having an average aspect ratio of 30 and an average major axis of 10 μm was used.

With 50 g of the obtained glass ceramic powder mixture (glass ceramic composition), 15 g of an organic solvent (a mixture of toluene, xylene, 2-propanol and 2-butanol in a mass ratio of 4:2:2:1), 2.5 g of a plasticizer (di-2-ethylhexyl phthalate), 5 g of polyvinyl butyral (manufactured by Denki Kagaku Kogyo Kabushiki Kaisha, tradename: PVK#3000K) as a binder and 0.5 g of a dispersing agent (manufactured by BYK Chemie, tradename: BYK180) were blended and mixed to obtain a slurry.

This slurry was cast onto a PET film by a doctor blade method and dried, and then the film was cut to produce a 40 mm square (40 mm in length × 40 mm in width) green sheet having a thickness of 200 μm.

Then, one or a predetermined number of green sheets were overlaid and bonded by applying a pressure of 10 MPa at 80°C. Then, the green sheet was held in a firing furnace at 550°C for 5 hours to decompose and remove the binder resin, and then held at 870°C for 30 minutes to carry out firing. In such a manner, a glass ceramic substrate for evaluation of properties was obtained. In preparation of substrates for evaluation, three substrates having a thickness after firing of about 120 μm, about 240 μm and about 360 μm were prepared by firing only one green sheet or a laminate of two or three green sheets.

With respect to each substrate for evaluation thus obtained, the dimensions in the plane direction were measured, whereupon the shrinkage in the plane direction by firing was calculated.

Further, with respect to each of the substrates for evaluation having the respective thicknesses, the reflectance to light in the entire visible region (400 to 700 nm) was measured by a spectroscope USB2000 and a small integrating sphere ISP-RF manufactured by Ocean Optics. As a reference, barium sulfate was used, and the reflectance was calculated as the reflectance on the plane coated with barium sulfate being 100%. The reflectance when the substrate for evaluation has a thickness of 300 μm was calculated by linear interpolation of a graph obtained by plotting the obtained reflectances measured relative to the thickness of the substrate for evaluation.

Further, XRD of the glass ceramic constituting the substrate for evaluation was measured. From the obtained XRD chart, a peak derived from glass having an intensity of at least 10 by the absolute value was examined, when the maximum intensity (absolute value) of a peak derived from alumina of the filler was 100, to calculate the degree of crystallization of glass. Further, the following parameter P was calculated.

$$\text{Parameter P} = \frac{\text{(average aspect ratio (A) of alumina filler} \times \text{blend ratio (c) (vol\%) of alumina filler} \times \text{difference in the refractive index between alumina filler and glass)}}{\text{average major axis (d) (μm) of alumina filler}}$$

As the refractive index of alumina constituting the filler is 1.76 and the calculated value of the refractive index of glass is 1.55, the above value P was determined assuming that the difference in the refractive index between the alumina filler and glass is 0.21. The reflectance of the substrate and the shrinkage in the plane direction at the time of firing thus calculated, and the degree of crystallization of glass determined from the XRD chart are shown in Table 2.

TABLE 2

| | Glass powder | Alumina filler | | | Properties of substrate | | | |
|---|---|---|---|---|---|---|---|---|
| | Blend ratio (vol%) | Average aspect ratio A | Average major axis d ($\mu$m) | Blend ratio c vol%) | Reflectance (%) | Shrinkage (%) in plane direction (x axis direction) | Degree of crystallization of glass by XRD | Calculated value of parameter P *2 |
| Ex. 1 | 50 | 25 | 2 | 50 | 91.6 | 2.4 | - (*1) | 131 |
| Ex. 2 | 50 | 37.5 | 2 | 50 | 91.2 | 1.4 | - (*1) | 197 |
| Ex. 3 | 50 | 50 | 2 | 50 | 95.9 | 0.7 | - (*1) | 263 |
| Ex. 4 | 60 | 50 | 2 | 40 | 92.1 | 1.2 | - (*1) | 210 |
| Ex. 5 | 70 | 50 | 2 | 30 | 84.6 | 4.0 | - (*1) | 158 |
| Ex. 6 | 50 | 70 | 5 | 50 | 96.0 | 6.2 | - (*1) | 147 |
| Comp. Ex. 1 | 50 | 5 | 2 | 50 | 74.8 | 12.5 | - (*1) | 26 |
| Comp. Ex. 2 | 50 | 30 | 10 | 50 | 69.4 | 13.1 | - (*1) | 32 |

*1: No crystallization peak except for a peak derived from the alumina filler observed.
*2: Parameter P: (A·c·difference in refractive index)/d

As shown in Table 2, the glass ceramic substrate in each of Examples 1 to 6 in which a flat alumina filler having an average aspect ratio of at least 25 was used, and this alumina filler was contained in a state where it was aligned in parallel with the plane direction of the substrate, has a remarkably high reflectance of light in the visible region and has an extremely high reflectance of at least 84% at a thickness of 300 $\mu$m, as compared with the glass ceramic substrate in Comparative Example 1 in which a flat alumina filler having an average aspect ratio less than 25 was used or the glass ceramic substrate in Comparative Example 2 in which a large alumina filler having an average major axis of 10 $\mu$m was used. Further, of each of the substrates in these Examples, the firing shrinkage in the plane direction is reduced. It is evident from the results of measurement of the degree of crystallization of glass that each of the glass ceramic substrates in Examples 1 to 6 contains substantially no crystals except for the alumina filler. That is, in the XRD chart in Examples 1 to 6, when the intensity of the maximum peak derived from the alumina filler is 100, a peak having an intensity of at least 10 derived from other crystalline component was not observed, and it was confirmed that no crystals derived from the glass powder was found.

Further, the plane shrinkage at the time of firing was linearly changed depending on e.g. the alumina content, the average aspect ratio of the alumina filler, etc., and it was confirmed that the plane shrinkage can optionally be controlled within a certain range.

INDUSTRIAL APPLICABILITY

According to the present invention, by using a flat filler having an average aspect ratio of at least 25 made of an oxide type ceramic and incorporating the flat ceramic filler in a state where it is aligned in parallel with the plane direction of the substrate, the reflectance of a substrate for mounting a light-emitting element to light in the visible region can be increased, and a high reflectance of at least 84% at a thickness of 300 $\mu$m of the substrate for mounting a light-emitting element can be realized. Further, by mounting a light-emitting element on the substrate for mounting a light-emitting element, a light-emitting device having high brightness and having good properties can be obtained.

The entire disclosure of Japanese Patent Application No. 2010-024630 filed on February 5, 2010 including specification, claims, drawings and summary is incorporated herein by reference in its entirety.

REFERENCE SYMBOLS

| 1: | Glass |
| 2: | Ceramic filler |
| 10: | Glass ceramic |
| 11: | Substrate for mounting light-emitting element |
| 12: | Light-emitting element |
| 15: | Bonding wire |
| 16: | Mold sealing layer |
| 20: | Light-emitting device |

**Claims**

1. A substrate for mounting a light-emitting element, which is a glass ceramic substrate made of a sintered product of a glass ceramic composition containing a glass powder and a flat ceramic filler having an average aspect ratio of at least 25, made of an oxide, and containing no crystals except for the ceramic constituting the filler, wherein the ceramic filler is aligned in parallel with the plane direction of the substrate, and the reflectance of light in the visible region is at least 84% at a thickness of 300 μm.

2. The substrate for mounting a light-emitting element according to Claim 1, wherein the average major axis of the flat ceramic filler is at least 1 μm and at most 5 μm.

3. The substrate for mounting a light-emitting element according to Claim 1 or 2, wherein the average aspect ratio of the flat ceramic filler is at least 25 and at most 200.

4. The substrate for mounting a light-emitting element according to any one of Claims 1 to 3, wherein in the glass ceramic composition, the blend ratio of the ceramic filler is from 30 to 60 vol%.

5. The substrate for mounting a light-emitting element according to any one of Claims 1 to 4, wherein in the glass ceramic composition, the blend ratio of the ceramic filler is from 30 to 60 vol%, and the blend ratio of the glass powder is from 40 to 70 vol%.

6. The substrate for mounting a light-emitting element according to any one of Claims 1 to 5, which is made of a sintered product of a glass ceramic composition containing a glass powder and a flat ceramic filler having an average aspect ratio of at least 25, made of an oxide, the glass powder being made of non-crystallized glass.

7. The substrate for mounting a light-emitting element according to any one of Claims 1 to 6, wherein when the refractive index of the glass is "a", and the refractive index of the ceramic constituting the ceramic filler is b, the absolute value of b-a is at least 0.15.

8. The substrate for mounting a light-emitting element according to any one of Claims 1 to 7, wherein of the ceramic filler, the value of (average aspect ratio x blend ratio (vol%) × difference in the refractive index with glass)/average major axis (μm) is at least 130.

9. A light-emitting device comprising the substrate for mounting a light-emitting element as defined in any one of Claims 1 to 8, and a light-emitting element mounted on the substrate for mounting a light-emitting element.

F i g.1

F i g.2

**INTERNATIONAL SEARCH REPORT**

| | International application No. |
|---|---|
| | PCT/JP2010/071390 |

A.   CLASSIFICATION OF SUBJECT MATTER
*H01L33/48*(2010.01)i, *C04B35/00*(2006.01)i, *H01L23/12*(2006.01)i, *H01L23/15*(2006.01)i, *H01L33/60*(2010.01)i

According to International Patent Classification (IPC) or to both national classification and IPC

B.   FIELDS SEARCHED

Minimum documentation searched (classification system followed by classification symbols)
H01L33/48, C04B35/00, H01L23/12, H01L23/15, H01L33/60

Documentation searched other than minimum documentation to the extent that such documents are included in the fields searched
| Jitsuyo Shinan Koho | 1922–1996 | Jitsuyo Shinan Toroku Koho | 1996–2011 |
| Kokai Jitsuyo Shinan Koho | 1971–2011 | Toroku Jitsuyo Shinan Koho | 1994–2011 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 9-71472 A  (Sumitomo Metal Mining Co., Ltd.), 18 March 1997 (18.03.1997), paragraphs [0010] to [0018] (Family: none) | 1-9 |
| Y | JP 2009-302110 A  (Mitsubishi Plastics, Inc.), 24 December 2009 (24.12.2009), paragraphs [0008], [0012], [0019] to [0021], [0028] (Family: none) | 1-9 |

☐   Further documents are listed in the continuation of Box C.      ☐   See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 24 January, 2011 (24.01.11) | 01 February, 2011 (01.02.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9071472 A
- JP 2002111210 A
- JP 2007121613 A
- JP 2010024630 A

**Non-patent literature cited in the description**

- **A. A. APPEN.** Chemistry of Glass. Nisso Tsu-shin-Sha, 1974, 318